# EUROPEAN PATENT SPECIFICATION

(11) **EP 3 547 359 B1**
(45) Date of publication and mention of the grant of the patent: **26.08.2026**
(21) Application number: 18305373.5
(22) Date of filing: 30.03.2018
(51) Int. Cl.: H10W 70/05, H10W 70/09, H10W 70/60, H10W 90/10, H10W 70/68, H10W 72/90, H10W 72/00

(54) **PRE-PACKED POWER CELL WITH A POWER DIE EMBEDDED IN A SUBSTRATE**
VORGEHÄUSTE LEISTUNGSZELLE MIT EINEM IN EINEM SUBSTRAT EINGEBETTETEN LEISTUNGSCHIP
CELLULE DE PUISSANCE PRÉ-EMBALLÉE AVEC UNE PUCE DE PUISSANCE INTÉGRÉE DANS UN SUBSTRAT

(43) Date of publication of application: 02.10.2019
(73) Proprietor: Mitsubishi Electric R&D Centre Europe BV, 1119 NS Schiphol Rijk Amsterdam (NL); Mitsubishi Electric Corporation, Tokyo 100-8310 (JP)
(72) Inventor: PERRIN, Rémi, 35708 Rennes Cédex 7 (FR); MORAND, Julien, 35708 Rennes Cédex 7 (FR); MRAD, Roberto, 35708 Rennes Cédex 7 (FR); EWANCHUK, Jeffrey, 35708 Rennes Cedex 7 (FR); MOLLOV, Stefan, 35708 Rennes Cédex 7 (FR)
(74) Representative: Plasseraud IP

(56) References cited:
- DE-A1- 102008 040 906
- US-A1- 2016 293 579

## Description

### FIELD OF THE INVENTION

The invention relates to a pre-packed power cell comprising a power die embedded in a substrate, to a power module comprising such a pre-packed power cell, and to a manufacturing method thereof.

### TECHNICAL BACKGROUND

Power dies, such as diodes or various types of transistors (MOSFET, JFET, IGBT) are elementary components of power modules which are used for the control and conversion of electric power, for instance in applications such as the automotive or aeronautic industries.

Currently the most common way to connect a power die to other components, for instance in a power module, is by using an insulated plate such as Direct Bonded Copper (DBC) Substrate, which comprises a ceramic tile covered on at least one side with a sheet of copper. Power dies are soldered or sintered on the DBC Substrate on one side, and connected on the other side of the die by wire bonded or ribbons that are ultrasonic welded on the die metallization.

The constant increase in switching frequency and power density of power dies leads to a constant need for thermal enhancement, volume reduction and reliability increase of the power modules.

In this perspective, the traditional connection of a power die on a substrate has a number of limitations and drawbacks, among which the high parasitic level and low reliability of the wire bonds, as well as the inductance they incur.

Moreover, the manufacturing process of a power module is quite complex and expensive because of the fragility of the power dies, and also because the electrical contacts of a power die are very small, which makes it difficult to perform wire-bonding. The complex manufacturing process also implies a lack of flexibility in the power dies placement because the available space is allocated according to the design and the possibilities of connections of the various dies.

An emerging technology proposes embedding dies in PCB substrate in order to obtain pre-packed power cells. For instance, document US2016/0240471 (A1) proposes to embed wide band-gap dies such as GaN transistors in a PCB substrate in order to reduce the drawbacks incurred by the wire bonds, and in particular to bring contact pads of the cell as close as possible to the die itself.

It is also known from document US 9425131 (B2) a packaged structure incorporating at least one electronic component embedded in a PCB substrate and connected to conductive layers through vias. In this type of structure the PCT substrate is used as a mechanical layer to easily connect the die to larger electrical contacts. Moreover, the embedding of the die inside a substrate reduces the mechanical stresses on the die and increases the reliability and lifetime of the die. The fabrication process is also simplified.

However the structure disclosed in this document is not adapted for high power applications, because it can be anticipated that the low thickness of the conductive layers and the limited number of vias to connect said layers to the die are not appropriate for transmitting high currents. Moreover for high power applications the thermal dissipation provided by this structure may not be sufficient.

The document DE 102008040906 (A1) provides a packaged structure of power cell comprising a power die (transistors particularly) embedded in an electrically insulating core and connected to conductive layers through vias. It is also embedded a cooling system to dissipate the heat of the board when several cells are connected to form H-Bridge or other power electronic structures.

### PRESENTATION OF THE INVENTION

In view of the above, the invention aims at providing a power electronic packaging which is more reliable, more robust, easier to produce and less expensive than in the prior art.

Another aim of the invention is to provide a packaging of an electronic component that is adapted to high power applications, in particular by allowing efficient thermal and current spreading.

Another aim of the invention is to provide an elementary cell having a packed power die which placement in a power module can be rendered mode flexible in order to further reduce the manufacturing cost and complexity of a power module. Accordingly, a pre-packed power cell is disclosed, comprising:
- a power die, having at least two electrical contacts on opposite sides of the power die,
- an electrically insulating core, wherein the power die is embedded in the electrically insulating core,
- two first electrically conductive layers embedded in the electrically insulating core and having contact pads respectively connected to each electrical contact of the power die through first vias arranged in the electrically insulating core,
- two second electrically conductive layers on opposite main surfaces of the core, and having contact pads respectively connected to the contact pads of each first electrically conductive layer through second vias arranged in the electrically insulating core,

characterized in that the second electrically conductive layers have a thickness greater than the thickness of the first electrically conductive layers,
in that the surface area of a contact pad of a first electrically conductive layer is greater than the surface area of the electrical contact of the power die to which it is connected,
and in that the surface area of a contact pad of a second electrically conductive layer is greater than or equal to the surface area of the contact pad of the first electrically conductive layer to which it is connected.

In embodiments, the thickness of the second electrically conductive layers is at least ten times the thickness of the first electrically conductive layers.

The electrically insulating core may be made in one of the following materials: FR4, polyimide, HTCC, LTCC.

The pre-packed power cell may have electrical contacts arranged in the second electrically conductive layers, and formed by the contact pads of said second electrically conductive layers.

In embodiments, the pre-packed power cell comprises a density of first vias between each first electrically conductive layer and respectively each electrical contact of the power die of at least 30 vias/mm².

The density of second vias between each first electrically conductive layer and respectively each second electrically conductive layer may be lower or equivalent than the density of first vias.

In embodiments, the pre-packed power cell may further comprise a control die adapted to control the power die, the control die being embedded in the electrically insulating core and being connected to the first electrically conductive layers by third vias arranged in the electrically insulating core.

The power die is preferably connected to the control die through the first electrically conductive layers.

The power die may be a wide band gap semiconductor device.

The pre-packed power cell may further comprise at least one passive component embedded in the electrically insulating core and being connected to the second electrically conductive layers by fourth vias.

According to another object, a power module is disclosed comprising at least a substrate and a plurality of power dies connected to the substrate, wherein the power module comprises at least one pre-packed power cell according to the description above, each pre-packed power cell being connected to the substrate and incorporating one of the power dies of the power module.

According to another object, a method for manufacturing a pre-packed power cell in accordance with claim 12 is disclosed.

The first drilling step is preferably performed by laser drilling and the second drilling step is performed by mechanical drilling.

Each step of metallizing holes may be performed by electro-deposition.

Preferably, the second holes have a diameter of at least 0.4 mm, and the method further comprises a step of filling the second holes.

The proposed invention resolves the above recited problems by close coupling a power die to thick electrically conductive layers through intermediate, thinner electrically conductive layers and respective vias. The surface increase between the electrical contact of the die and the thicker electrically conductive layers, allows transmitting high currents to the die and allows efficient thermal dissipation. Moreover the intermediate thin layer allows laser drilling of a great density of thin vias between the intermediate thin layer and the power die, while the thick external layers require mechanical drilling of enlarges vias. The thin layer also acts as an intermediate for the manufacturing process.

The proposed pre-packed power cell improves the robustness of the die by embedding the die in an insulating substrate, and facilitates the embedding process and the subsequent integration as well as the reliability of a power module incorporating said cell.

In addition, the invention makes it possible to incorporate a control die of a power die inside a pre-packed power cell, to bring a control dies and power die closer from one another and further reduce parasitic effects and resistance incurred by lengthy connections.

### DESCRIPTION OF THE DRAWINGS

Other features and advantages of the invention will be apparent from the following detailed description given by way of non-limiting example, with reference to the accompanying drawings, in which:
- Figures 1a and 1b schematically show a pre-packed power cell according to two embodiments of the invention
- Figure 2 schematically shows a power module comprising at least one pre-packed power cell according to an embodiment of the invention,
- Figure 3 is a diagram showing the main steps of a manufacturing process according to an embodiment of the invention.
- Figures 4a to 4d schematically represent the main steps of a manufacturing process according to an embodiment of the invention.

### DETAILED DESCRIPTION OF AT LEAST ONE EMBODIMENT OF THE INVENTION

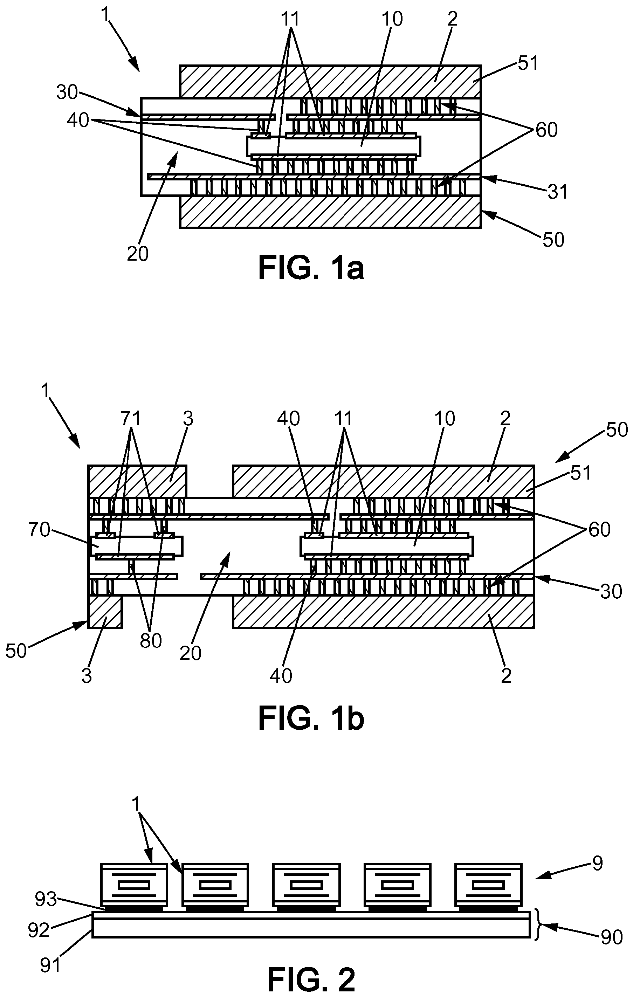

With reference to figures 1a and 1b, a pre-packed power cell 1 according an embodiment of the invention will now be described.

The pre-packed power cell 1 comprises a power die 10. The power die may be a diode or a transistor such as a MOSFET, JFET or IGBT. In embodiments, the power die 10 is made from a wide bandgap semiconductor, i.e a semiconductor having a bandgap in the range of 2-4 eV. For instance, the power die may be made in Silicon Carbide SiC or in Gallium Nitride GaN.

The power die has electrical contacts 11 on opposite sides of the power die. In an embodiment, the power die 10 is a diode and has two electrical contacts. In another embodiment, the power die 10 is a transistor and has three electrical contacts comprising a gate, a source and a drain, or a gate, an emitter and a collector, according to the type of transistor.

The pre-packed power cell 1 further comprises an electrically insulating core 20, in which the power die 10 is embedded. Preferably, the electrically insulating core has low thermal resistance to provide better heat dissipation.

The electrically insulating core 20 may be made of FR-4 glass epoxy, polyimide, or in ceramic such as HTCC (High Temperature Co-fired Ceramic) or LTCC (Low Temperature Co-fired Ceramic).

In addition, the pre-packed power cell 1 further comprises two first electrically conductive layers 30, also embedded in the electrically insulating core 20 and arranged on both sides of the power die. Each first electrically conductive layer 30 is connected to at least an electrical contact of the power die through respective first vias 40 arranged in the electrically insulating substrate.

The first electrically conductive layers 30 are patterned to be properly connected to the contacts of the power die. In particular, each electrically conductive layer 30 has at least one contact pad 31 adapted to be connected to a respective contact of the power die.

Last, the pre-packed power cell 1 further comprises two second electrically conductive layers 50, which are positioned on opposite main surfaces of the electrically insulating core 20. Each second electrically conductive layer 50 is also patterned to provide appropriate connections to other components, for instance components of a power module.

Each second electrically conductive layer 50 comprises at least one contact pad 51 connected to a respective contact pad 31 of a first electrically conductive layer 30 through respective second vias 60 arranged in the electrically insulating substrate.

The first and second electrically conductive layers are preferably made in copper.

In addition, as shown schematically on figure 1, the thickness of the second electrically conductive layers 50 is greater than the thickness of the first electrically conductive layers 30. Preferably, the thickness of the second electrically conductive layers is at least ten times the thickness of the first electrically conductive layers. For instance, the thickness of the first electrically conductive layers may be about 35 µm, and the thickness of the second electrically conductive layers may be at least 70 µm, for instance equal to 400 µm.

Moreover, the surface area of a contact pad of a second electrically conductive layer 50 is greater than or equal to the surface area of the contact pad 31 of a first electrically conductive layer 31 to which it is connected; and the surface area of said contact pad 31 of the first electrically conductive layer 30 is greater than the surface area of the power die electrical contact 11 to which it is connected.

The contact pads 51 of a second electrically conductive layer also form electrical contacts 2 of the power cell 1, for its connection to other components, for instance within a power module.

Therefore, the electrical contacts of the power cell 1 are larger than those 11 of the power die 10. This offers an improved and a flexible fan out for a final assembly process of a power module including such a power cell. It also reduces the complexity and the precision requested during the assembly process.

Moreover, the thick second conductive layers 50 allow high current flow to the power die by decreasing the resistivity of the current path. This current flow is transmitted to the thin first conductive layers 30 through the second vias 60, and in turn to the power die 10 through the first vias 40. To this end, given the reduced surface area of the power die electrical contacts 11, the first vias 40 are arranged with a density of at least 30 vias/mm², for instance with a ratio vias hole depth to drill diameter of 1:2.5.

The connection surface between each first electrically conductive layer and a respective second electrically conductive layer being greater, the density of second vias 60 needs not be as high. It is therefore inferior or equal to the density of the first vias 40. For instance, it can thus inferior or equal to 30 vias/mm². In that case the diameter of the second vias 60 can be greater than the diameter of the first vias. For example, with a ratio vias hole depth to drill diameter of 1:1.

This connection to the power die allows a low impact on the resistivity of the assembly stack. In particular, the on and off resistance of the power die are not affected and the electric losses are quite low. This important density of vias also contributes to heat dissipation.

In an embodiment, an example of which being shown on figure 1a, the pre-packed power cell comprises only a power die. In this embodiment, integration of the power cell 1 in a power module is rendered easy because the connection of power cell electrical contacts to a substrate is easier than with smaller contacts of a power die. Thus it is no longer necessary to adapt the design of a power module to the design or the connection possibilities of a cell; hence new design possibilities are offered.

In an alternative embodiment, the power cell 1 may incorporate other components. In a preferred embodiment, the power cell 1 comprises, in addition to a power die 10, a control die 70 adapted to control the power die 10.

In that case, the control die 70, also having respective electrical contacts 71, is also embedded in the electrically insulating substrate. The control die 70 is connected to the power die through the first electrically conductive layers, to which it is connected by third vias 80. The control die 70 is thus also connected to the second electrically conductive layers 50 through the first electrically conductive layers 30, and can be controlled by respective electrical contacts 3 arranged in the second electrically conductive layers.

This embodiment is particularly preferred for power dies made of wide bandgap semiconductors, because the latter exhibit high commutation frequencies, and the incorporation of a power die in the power cell allows bringing the control die closer to the power die and hence reducing parasites in their connection.

The power cell 1 may further comprise additional components (not shown), for instance passive components such as capacitors, or integrated circuit dies, to incorporated additional functionalities. In that case, these components are also embedded in the electrically insulating substrates, and connected to the second electrically conductive layers by respective vias (not shown).

With reference to figure 2, a power module 9 is shown, comprising a plurality of pre-packed power cells 1 according to the description above. The power module can be for instance an inverter or a power converter.

The power module 9 may comprise at least one substrate 90 having a layer 91 of highly thermally conductive material on which an electrically conductive layer 92 (e.g. copper layer) is patterned to match the size and shape of the electrical contacts of the pre-packaged power cell 1 and to provide the desired connections between the dies contained in the respective power cells 1. Each power cell 1 is attached on one side of the substrate by an electrically and thermally conductive interconnection material 93 such as solder, silver sinter or conductive paste.

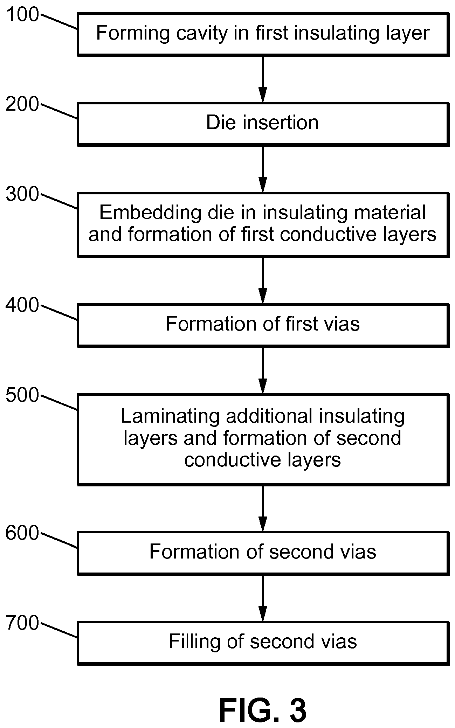

With reference to figure 3, a method for manufacturing a pre-packed power cell 1 according to the description above will now be described.

During a first step 100, at least one cavity having the size of a power die is formed in a first layer 20a of electrically insulating material. The cavity may be obtained by positioning a wedge having the size of a power die during the manufacturing of the first layer, and then removing the wedge.

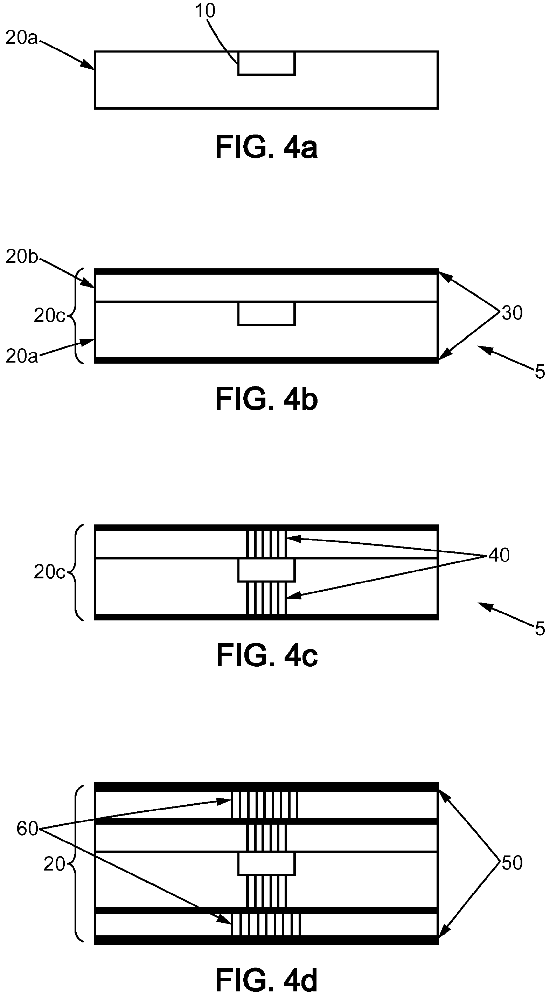

During a second step 200, a power die 10 is inserted in the cavity. Figure 4a represents the structure obtained at the end of step 200.

In an embodiment in which the pre-packed power cell comprises another cavity, for instance for a control die of the power die, step 100 also comprises forming an additional cavity for the control die. Step 200 then comprises the insertion of the control die in the additional cavity.

During a step 300, a second layer 20b of electrically insulating material is laminated on top of the first layer 20a in order to embed the power die therein. This step also comprises forming, on opposite main surfaces of the thus obtained layer of electrically insulating material, two first electrically conductive layers 30. In one embodiment, the two first electrically conductive layers 30 may be obtained by electrodeposition. In another embodiment, step 300 may comprise laminating second layers 22 of electrically insulating material and first layers of electrically conductive material simultaneously on opposite sides of the layer of electrically insulating material embedding the power die. The first electrically conductive layers are etched to obtain the desired connection patterns.

At this point an intermediate structure 5 comprising a layer 20c of electrically insulating material between two first layers of electrically conductive material is obtained. A schematic representation of this intermediate structure 5 is shown in figure 4b.

As schematically shown in figure 4c, during a step 400 first holes are drilled and metallized to form the plurality of first vias at the desired density of at least 30 vias/mm², the vias extending from each first layer of electrically conductive material to the electrical contacts of the power die. The drilling step may be performed by laser drilling.

A step 500 then comprises laminating additional electrically insulating layers on opposite main surfaces are formed on opposite main free surfaces of the intermediate structure 5, and forming second electrically conductive layers on the additional insulating layers. This step is performed in a similar way as step 300, except it comprises additional steps of metal deposition in order to obtain the desired thickness of the second electrically conductive layers. The second electrically conductive layers are then etched to obtain the desired connection patterns.

During a step 600, second holes are drilled and metallized in order to obtain second vias connecting the second electrically conductive layers to the first ones. This step can be performed by mechanical drilling.

As mentioned hereinbefore, the density of the second vias can be lower than the density of the first vias and hence the diameter of the second vias can be more important, for instance with a ratio hole depth to drill diameter of 1:1 . In that case, the method can then comprise an additional step 700, of filling the second vias with electrically conductive material so that the second vias can transmit a desired current density to the first electrically conductive layers. This step can be performed by electrodeposition.

In an embodiment, the method comprises forming at step 500 second electrically conductive layers at a thickness lower than the desired thickness, forming the second vias at step 600, and then filling the vias and increasing the thickness of the second electrically conductive layers at step 700 by electrodeposition.

The pre-packed power cell 1 is then obtained and shown schematically in figure 4d. Additionally, some specific treatments, which may be chemical, mechanical or other, may be performed on the second electrically conductive layers 50 in order to facilitate interfacing of the power cell to an external assembly. As a non-limiting example, those treatments can comprise deposition on the surface of the pre-packed power cell of other metals such as a Nickel-gold or Silver deposition for latter sintering.

If the pre-packed power cell comprises additional components such as passive components, they can be embedded in the electrically insulating core with the power dies and connected to the second layers of electrically conductive materials through vias arranged in the core.

## Claims

1. A pre-packed power cell (1) comprising :
- a power die (10), having at least two electrical contacts (11) on opposite sides of the power die (10),
- an electrically insulating core (20), wherein the power die (10) is embedded in the electrically insulating core (20),
- two first electrically conductive layers (30) embedded in the electrically insulating core (20) and having contact pads (31) respectively connected to each electrical contact (11) of the power die (10) through first vias (40) arranged in the electrically insulating core (20),
- two second electrically conductive layers (50) on opposite main surfaces of the core (20), and having contact pads (51) respectively connected to the contact pads (31) of each first electrically conductive layer (30) through second vias (60) arranged in the electrically insulating core (20),
**characterized in that** the second electrically conductive layers (50) have a thickness greater than the thickness of the first electrically conductive layers (30),
**in that** the surface area of a contact pad (31) of a first electrically conductive layer (30) is greater than the surface area of the electrical contact (11) of the power die (10) to which it is connected,
and **in that** the surface area of a contact pad (51) of a second electrically conductive layer (50) is greater than or equal to the surface area of the contact pad (31) of the first electrically conductive layer (30) to which it is connected.

2. A pre-packed power cell according to claim 1, wherein the thickness of the second electrically conductive layers (50) is at least ten times the thickness of the first electrically conductive layers (30).

3. A pre-packed power cell according to claim 1 or 2, wherein the electrically insulating core (20) is made in one of the following FR-4 glass epoxy, polyimide, high-temperature co-fired ceramic or low-temperature co-fired ceramic.

4. A pre-packed power cell (1) according to any of the preceding claims, wherein the pre-packed power cell (1) has electrical contacts (2) arranged in the second electrically conductive layers (50), and formed by the contact pads (51) of said second electrically conductive layers (50).

5. A pre-packed power cell (1) according to any of the preceding claims, comprising a density of first vias (40) between each first electrically conductive layer (30) and respectively each electrical contact (11) of the power die (10) of at least 30 vias/mm².

6. A pre-packed power cell (1) according to any of the preceding claims, comprising a density of second vias (60) between each first electrically conductive layer (30) and respectively each second electrically conductive layer (50) that is lower than or equivalent to the density of first vias. ².

7. A pre-packed power cell (1) according to any of the preceding claims, further comprising a control die (70) adapted to control the power die (10), the control die (70) being embedded in the electrically insulating core (20) and being connected to the first electrically conductive layers (30) by third vias (80) arranged in the electrically insulating core.

8. A pre-packed power cell according to claim 8, wherein the power die (10) is connected to the control die (70) through the first electrically conductive layers (30).

9. A pre-packed power cell (1) according to claim 8 or 9, wherein the power die (10) is a wide band gap semiconductor device.

10. A pre-packed power cell (1) according to any of the preceding claims, further comprising at least one passive component embedded in the electrically insulating core and being connected to the second electrically conductive layers by fourth vias.

11. A power module (9), comprising at least a substrate (90) and a plurality of power dies (10) connected to the substrate (90), wherein the power module (9) comprises at least one pre-packed power cell (1) according to any of the preceding claims, each pre-packed power cell (1) being connected to the substrate (90) and incorporating one of the power dies (10) of the power module.

12. A method for manufacturing a pre-packed power cell (1) according to any of claims 1 to 10, comprising :
- forming (100) at least a cavity of a size of a power die (10) in a first layer (20a) of electrically insulating material,
- placing (200) the or each power die in a respective cavity, wherein the or each power die comprises electrical contacts (11) on opposite sides thereof,
- laminating (300) an electrically isolating layer (20b) on top of the first layer (20a) of electrically insulating material, and forming first electrically conductive layers (30) on opposite sides of the obtained layer of electrically isolating layer in order to obtain an intermediate structure (5) comprising a layer of electrically insulating material, embedding the power die, between two first layers of electrically conductive material,
- drilling (400) first holes and metallizing the first holes in order to connect the at least one power die to the electrically conductive layers,
- etching the first electrically conductive layers in order to obtain a layout comprising contact pads (31) connected to respective contacts (11) of the or each power die (10),
- laminating (500) additional isolation layers on opposite main surfaces of the intermediate structure, and providing second electrically conductive layers (50) on each additional isolation layer, wherein the second electrically conductive layers have a thickness greater than the thickness of the first electrically conductive layers,
- drilling (600) second holes and metallizing the second holes in order to form second vias (60) connecting the first and second electrically conductive layers,
- etching the second electrically conductive layers in order to obtain another layout comprising contact pads (51) connected to respective contact pads (31) of the first electrically conductive layer (30) through respective second vias (60) arranged in the electrically insulating substrate.

13. A method according to claim 12, wherein the first drilling step (400) is performed by laser drilling and the second drilling step (600) is performed by mechanical drilling.

14. A method according to claim 12 or 13, wherein each step of metallizing holes is performed by electro-deposition.

15. A method according to any of claims 12 to 14, wherein the second holes have a diameter of at least 0.4 mm, and the method further comprises a step of filling the second holes.

## Patentansprüche

1. Vorverpackte Leistungszelle (1), umfassend:
- einen Leistungschip (10), welcher wenigstens zwei elektrische Kontakte (11) an gegenüberliegenden Seiten des Leistungschips (10) aufweist,
- einen elektrisch isolierenden Kern (20), wobei der Leistungschip (10) in dem elektrisch isolierenden Kern (20) eingebettet ist,
- zwei erste elektrisch leitfähige Schichten (30), welche in dem elektrisch isolierenden Kern (20) eingebettet sind und Kontaktpads (31) aufweisen, welche jeweils mit jedem elektrischen Kontakt (11) des Leistungschips (10) durch erste Kontaktierungen (40) verbunden sind, welche in dem elektrisch isolierenden Kern (20) angeordnet sind,
- zwei zweite elektrisch leitfähige Schichten (50) an gegenüberliegenden Hauptflächen des Kerns (20), und welche Kontaktpads (51) aufweisen, welche jeweils mit den Kontaktpads (31) von jeder ersten elektrisch leitfähigen Schicht (30) durch zweite Kontaktierungen (60) verbunden sind, welche in dem elektrisch isolierenden Kern (20) angeordnet sind,
**dadurch gekennzeichnet, dass** die zweiten elektrisch leitfähigen Schichten (50) eine Dicke aufweisen, welche größer als die Dicke der ersten elektrisch leitfähigen Schichten (30) ist,
dass der Flächenbereich des Kontaktpads (31) einer ersten elektrisch leitfähigen Schicht (30) größer als der Flächenbereich des elektrischen Kontakts (11) des Leistungschips (10) ist, mit welchem es verbunden ist, und dass der Flächenbereich des Kontaktpads (51) einer zweiten elektrisch leitfähigen Schicht (50) größer oder gleich dem Flächenbereich des Kontaktpads (31) der ersten elektrisch leitfähigen Schicht (30) ist, mit welcher es verbunden ist.

2. Vorverpackte Leistungszelle nach Anspruch 1, wobei die Dicke der zweiten elektrisch leitfähigen Schichten (50) wenigstens zehnmal die Dicke der ersten elektrisch leitfähigen Schichten (30) beträgt.

3. Vorverpackte Leistungszelle nach Anspruch 1 oder 2, wobei der elektrisch isolierende Kern (20) aus einem der folgenden hergestellt ist: FR-4-Glasepoxy, Polyimid, Hochtemperatur-Einbrand-Keramik oder Niedertemperatur-Einbrand-Keramik.

4. Vorverpackte Leistungszelle (1) nach einem der vorhergehenden Ansprüche, wobei die vorverpackte Leistungszelle (1) elektrische Kontakte (2) aufweist, welche in den zweiten elektrisch leitfähigen Schichten (50) angeordnet und durch die Kontaktpads (51) der zweiten elektrisch leitfähigen Schichten (50) gebildet sind.

5. Vorverpackte Leistungszelle (1) nach einem der vorhergehenden Ansprüche, umfassend eine Dichte von ersten Kontaktierungen (40) zwischen jeder ersten elektrisch leitfähigen Schicht (30) und entsprechend jedem elektrischen Kontakt (11) des Leistungschips (10) von wenigstens 30 Kontaktierungen/mm²

6. Vorverpackte Leistungszelle (1) nach einem der vorhergehenden Ansprüche, umfassend eine Dichte von zweiten Kontaktierungen (60) zwischen jeder ersten elektrisch leitfähigen Schicht (30) und entsprechend jeder zweiten elektrisch leitfähigen Schicht (50), welche kleiner als oder äquivalent zu der Dichte der ersten Kontaktierungen ist.

7. Vorverpackte Leistungszelle (1) nach einem der vorhergehenden Ansprüche, ferner umfassend einen Steuerchip (70), welcher dazu eingerichtet ist, den Leistungschip (10) zu steuern, wobei der Steuerchip (70) in dem elektrisch isolierenden Kern (20) eingebettet und mit den ersten elektrisch leitfähigen Schichten (30) durch dritte Kontaktierungen (80) verbunden ist, welche in dem elektrisch isolierenden Kern angeordnet sind.

8. Vorverpackte Leistungszelle nach Anspruch 8, wobei der Leistungschip (10) mit dem Steuerchip (70) durch die ersten elektrisch leitfähigen Schichten (30) verbunden ist.

9. Vorverpackte Leistungszelle (1) nach Anspruch 8 oder 9, wobei der Leistungschip (10) eine Halbleitervorrichtung mit breiter Bandlücke ist.

10. Vorverpackte Leistungszelle (1) nach einem der vorhergehenden Ansprüche, ferner umfassend wenigstens eine passive Komponente, welche in dem elektrisch isolierenden Kern eingebettet und mit den zweiten elektrisch leitfähigen Schichten durch vierte Kontaktierungen verbunden ist.

11. Leistungsmodul (9), umfassend wenigstens ein Substrat (90) und eine Mehrzahl von Leistungschips (10), welche mit dem Substrat (90) verbunden sind, wobei das Leistungsmodul (9) wenigstens eine vorverpackte Leistungszelle (1) nach einem der vorhergehenden Ansprüche umfasst, wobei jede vorverpackte Leistungszelle (1) mit dem Substrat (90) verbunden ist und einen der Leistungschips (10) des Leistungsmoduls integriert.

12. Verfahren zum Herstellen einer vorverpackten Leistungszelle (1) nach einem der Ansprüche 1 bis 10, umfassend:
- Bilden (100) von wenigstens einem Hohlraum einer Größe eines Leistungschips (10) in einer ersten Schicht (20a) aus elektrisch isolierendem Material,
- Platzieren (200) des oder jedes Leistungschips in einem entsprechenden Hohlraum, wobei der oder jeder Leistungschip elektrische Kontakte (11) an gegenüberliegenden Seiten davon umfasst,
- Laminieren (300) einer elektrisch isolierenden Schicht (20b) auf die erste Schicht (20a) von elektrisch isolierendem Material und Bilden von ersten elektrisch leitfähigen Schichten (30) an gegenüberliegenden Seiten der erhaltenen Schicht aus elektrisch isolierender Schicht, um eine Zwischenstruktur (5) zu erhalten, welche eine Schicht aus elektrisch isolierendem Material umfasst, wobei der Leistungschip zwischen zwei ersten Schichten aus elektrisch leitfähigem Material eingebettet wird,
- Bohren (400) von ersten Löchern und Metallisieren der ersten Löcher, um den wenigstens einen Leistungschip mit den elektrisch leitfähigen Schichten zu verbinden,
- Ätzen der ersten elektrisch leitfähigen Schichten, um ein Layout zu erhalten, welches Kontaktpads (31) umfasst, welche mit entsprechenden Kontakten (11) des oder jedes Leistungschips (10) verbunden sind,
- Laminieren (500) von zusätzlichen Isolationsschichten an gegenüberliegende Hauptflächen der Zwischenstruktur und Bereitstellen von zweiten elektrisch leitfähigen Schichten (50) an jeder zusätzlichen Isolationsschicht, wobei die zweiten elektrisch isolierenden Schichten eine Dicke aufweisen, welche größer als die Dicke der ersten elektrisch leitfähigen Schichten ist,
- Bohren (600) von zweiten Löchern und Metallisieren der zweiten Löcher, um zweite Kontaktierungen (60) zu bilden, welche die ersten und zweiten elektrisch leitfähigen Schichten verbinden,
- Ätzen der zweiten elektrisch leitfähigen Schichten, um ein weiteres Layout zu erhalten, welches Kontaktpads (51) umfasst, welche mit entsprechenden Kontaktpads (31) der ersten elektrisch leitfähigen Schicht (30) durch jeweilige zweite Kontaktierungen (60) verbunden sind, welche in dem elektrisch isolierenden Substrat angeordnet sind.

13. Verfahren nach Anspruch 12, wobei der erste Bohrungsschritt (400) durch Laserbohren durchgeführt wird und der zweite Bohrungsschritt (600) durch mechanisches Bohren durchgeführt wird.

14. Verfahren nach Anspruch 12 oder 13, wobei jeder Schritt eines Metallisierens von Löchern durch Elektro-Ablagerung durchgeführt wird.

15. Verfahren nach einem der Ansprüche 12 bis 14, wobei die zweiten Löcher einen Durchmesser von wenigstens 0,4 mm aufweisen und das Verfahren ferner einen Schritt eines Füllens der zweiten Löcher umfasst.

## Revendications

1. Cellule d'alimentation préemballée (1) comprenant :
- une puce de puissance (10), comportant au moins deux contacts électriques (11) sur des côtés opposés de la puce de puissance (10),
- un noyau électriquement isolant (20), dans laquelle la puce de puissance (10) est intégrée au noyau électriquement isolant (20),
- deux premières couches électriquement conductrices (30) intégrées dans le noyau électriquement isolant (20) et comportant des plots de contact (31) respectivement connectés à chaque contact électrique (11) de la puce de puissance (10) à travers des premiers trous d'interconnexion (40) disposés dans le noyau électriquement isolant (20),
- deux secondes couches électriquement conductrices (50) sur des surfaces principales opposées du noyau (20), et comportant des plots de contact (51) respectivement connectés aux plots de contact (31) de chaque première couche électriquement conductrice (30) à travers des deuxièmes trous d'interconnexion (60) disposés dans le noyau électriquement isolant (20),
**caractérisé en ce que** les secondes couches électriquement conductrices (50) ont une épaisseur supérieure à l'épaisseur des premières couches électriquement conductrices (30), **en ce que** la surface d'un plot de contact (31) d'une première couche électriquement conductrice (30) est supérieure à la surface du contact électrique (11) de la puce de puissance (10) à laquelle elle est connectée, et **en ce que** la surface d'un plot de contact (51) d'une seconde couche électriquement conductrice (50) est supérieure ou égale à la surface du plot de contact (31) de la première couche électriquement conductrice (30) à laquelle elle est connectée.

2. Cellule d'alimentation préemballée selon la revendication 1, dans laquelle l'épaisseur des secondes couches électriquement conductrices (50) est au moins dix fois l'épaisseur des premières couches électriquement conductrices (30).

3. Cellule d'alimentation préemballée selon la revendication 1 ou 2, dans laquelle le noyau électriquement isolant (20) est réalisé dans l'un des matériaux suivants : époxy verre FR-4, polyimide, céramique à cuisson simultanée à haute température ou céramique à cuisson simultanée à basse température.

4. Cellule d'alimentation préemballée (1) selon l'une quelconque des revendications précédentes, dans laquelle la cellule d'alimentation préemballée (1) comporte des contacts électriques (2) disposés dans les secondes couches électriquement conductrices (50), et formés par les plots de contact (51) desdites secondes couches électriquement conductrices (50).

5. Cellule d'alimentation préemballée (1) selon l'une quelconque des revendications précédentes, comprenant une densité de premiers trous d'interconnexion (40) entre chaque première couche électriquement conductrice (30) et respectivement chaque contact électrique (11) de la puce de puissance (10) d'au moins 30 trous d'interconnexion/mm².

6. Cellule d'alimentation préemballée (1) selon l'une quelconque des revendications précédentes, comprenant une densité de deuxièmes trous d'interconnexion (60) entre chaque première couche électriquement conductrice (30) et respectivement chaque seconde couche électriquement conductrice (50) qui est inférieure ou équivalente à la densité des premiers trous d'interconnexion.

7. Cellule d'alimentation préemballée (1) selon l'une quelconque des revendications précédentes, comprenant en outre une puce de contrôle (70) adaptée pour contrôler la puce de puissance (10), la puce de contrôle (70) étant intégrée dans le noyau électriquement isolant (20) et étant connectée aux premières couches électriquement conductrices (30) par des troisièmes trous d'interconnexion (80) disposés dans le noyau électriquement isolant.

8. Cellule d'alimentation préemballée selon la revendication 8, dans laquelle la puce de puissance (10) est connectée à la puce de contrôle (70) par les premières couches électriquement conductrices (30).

9. Cellule de puissance préemballée (1) selon la revendication 8 ou 9, dans laquelle la puce de puissance (10) est un dispositif semi-conducteur à large bande interdite.

10. Cellule d'alimentation préemballée (1) selon l'une quelconque des revendications précédentes, comprenant en outre au moins un composant passif intégré dans le noyau électriquement isolant et étant connecté aux deuxièmes couches électriquement conductrices par des quatrièmes trous d'interconnexion.

11. Module d'alimentation (9), comprenant au moins un substrat (90) et une pluralité de puces de puissance (10) connectées au substrat (90), dans lequel le module d'alimentation (9) comprend au moins une cellule d'alimentation préemballée (1) selon l'une quelconque des revendications précédentes, chaque cellule d'alimentation préemballée (1) étant connectée au substrat (90) et incorporant l'une des puces de puissance (10) du module d'alimentation.

12. Procédé de fabrication d'une cellule d'alimentation préemballée (1) selon l'une quelconque des revendications 1 à 10, comprenant :
- la formation (100) d'au moins une cavité d'une taille d'une puce de puissance (10) dans une première couche (20a) de matériau électriquement isolant,
- la mise en place (200) de la ou de chaque puce de puissance dans une cavité respective, dans lequel la ou chaque puce de puissance comprend des contacts électriques (11) sur des côtés opposés de celle-ci,
- la stratification (300) d'une couche électriquement isolante (20b) sur la première couche (20a) de matériau électriquement isolant, et la formation de premières couches électriquement conductrices (30) sur les côtés opposés de la couche obtenue de couche électriquement isolante afin d'obtenir une structure intermédiaire (5) comprenant une couche de matériau électriquement isolant, incorporant la puce de puissance, entre deux premières couches de matériau électriquement conducteur,
- le perçage (400) de premiers trous et la métallisation des premiers trous afin de connecter l'au moins une puce de puissance aux couches électriquement conductrices,
- la gravure des premières couches électriquement conductrices afin d'obtenir une configuration comprenant des plots de contact (31) reliés aux contacts respectifs (11) de la ou de chaque puce de puissance (10),
- la stratification (500) de couches d'isolation supplémentaires sur les surfaces principales opposées de la structure intermédiaire, et la fourniture de secondes couches électriquement conductrices (50) sur chaque couche d'isolation supplémentaire, dans lequel les secondes couches électriquement conductrices ont une épaisseur supérieure à l'épaisseur des premières couches électriquement conductrices,
- le perçage (600) de deuxièmes trous et la métallisation des deuxièmes trous afin de former des deuxièmes trous d'interconnexion (60) reliant les premières et secondes couches électriquement conductrices,
- la gravure des secondes couches électriquement conductrices afin d'obtenir une autre configuration comprenant des plots de contact (51) reliés aux plots de contact respectifs (31) de la première couche électriquement conductrice (30) à travers des deuxièmes trous d'interconnexion respectifs (60) disposés dans le substrat électriquement isolant.

13. Procédé selon la revendication 12, dans lequel la première étape de perçage (400) est réalisée par perçage laser et la deuxième étape de perçage (600) est réalisée par perçage mécanique.

14. Procédé selon la revendication 12 ou 13, dans lequel chaque étape de métallisation de trous est réalisée par électrodéposition.

15. Procédé selon l'une quelconque des revendications 12 à 14, dans lequel les deuxièmes trous ont un diamètre d'au moins 0,4 mm, et le procédé comprend en outre une étape de remplissage des deuxièmes trous.
